# EUROPEAN PATENT APPLICATION

(11) **EP 2 400 574 A1**
(43) Date of publication of application: **28.12.2011**
(21) Application number: 10166939.8
(22) Date of filing: 22.06.2010
(51) Int. Cl.: H01L 41/193, H01L 41/26

(54) **Polymer sheet material with piezoelectric properties and a method for manufacturing**

(71) Applicant: Universität Potsdam, 14415 Potsdam (DE)
(72) Inventor: Gerhard, Reimund, 10623 Berlin (DE); Künstler, Wolfgang, 14478 Potsdam (DE); Solnyshkin, Alexander, 170021 Twer (RU)
(74) Representative: Schröder, Christoph

(57) **Abstract**

The invention relates to a polymer sheet material with piezoelectric properties comprising PVDF or co-polymers and method for manufacturing a polymer sheet material with piezoelectric properties comprising PVDF or co-polymers thereof by
a) subjecting the polymer sheet material (1) to an electric field (E) between two electrodes (21, 22), in particular a corona arrangement,
b) while subjecting the polymer sheet material (1) at the same time to a temperature treatment with a temperature of above 100°C,
c) during a) and b) the polymer sheet material (1) is positioned on a treatment surface (20),
d) wherein the treatment surface (20) comprises structural elements (3) for generating inhomogeneity in the electric field (E).

## Description

In the following a method for manufacturing a polymer material with piezoelectric properties comprising PVDF or co-polymers thereof according to claim 1 and a polymer sheet material with piezoelectric properties comprising PVDF or co-polymers thereof according to claim 14 are described.

Piezoelectric devices are used in many applications, such as e.g. stress sensors, vibration sensors filters, oscillators, mechano-electrical or electro-mechanical transducers. Among the piezoelectric materials polymers have the advantage that they are very light weight and flexible. In recent years different polymer materials with piezoelectric properties have been found. The piezoelectric and pyroelectrical properties are caused by the alignment of molecular dipoles and / or ferroelectric domains.

It is known in the art that PVDF (polyvinylidene fluoride) can be made piezoelectric by a combination of mechanical stretching and electrical field poling at elevated temperatures. These measures introduce anisotropies within the polymer which gives rise to piezoelectric properties. Using known techniques piezoelectric d-coefficients in the range of 20 to 35 pC/N can be reached.

Even though these values are higher than in other polymers, it is desirable to increase the piezoelectric coefficient. A high piezoelectric coefficient is in all application areas concerning mechano-electrical or electro-mechanical converters, e.g. microphones or speakers, advantageous. An enhancement in the piezoelectric properties can lead to an enormous increased performance.

This is achieved by a polymer sheet material with the features of claim 14. Such a polymer sheet material is producible, preferably produced by a method according to claim 1.

The polymer sheet material with piezoelectric properties comprising PVDF or co-polymers thereof is subjected to an electric field between two adjacent electrodes or in a corona arrangement. At the same time the polymer sheet material is exposed to a temperature of above 100°C. During the temperature treatment and the simultaneous subjection to an electric field the polymer sheet material is positioned, on a treatment surface, which comprises structural elements for generating inhomogeneity in the electric field. The inhomogeneity of the electric field induces additional anisotropy in the polymer sheet material resulting in improved piezoelectric properties.

In an embodiment the total area of the bottom side of the polymer sheet material is in contact with the structural elements of the treatment surface. Alternatively the bottom side of the polymer sheet material is only partially in contact with the structural elements of the treatment surface, for inducing additional anisotropy in a specific area of the in the polymer sheet material resulting in improved piezoelectric properties in this specific area.

The structural elements comprise the same or different characteristics, e.g. structure, direction, shape and dimension.

In an embodiment at least parts of the structural elements are arranged below a reference plane, in particular by indentations into at least parts of the treatment surface. Alternatively at least parts of the structural elements are arranged above the reference plane, in particular by protruding elements on at least parts of the treatment surface. In an alternative embodiment the structural elements, comprise indentations as well as protruding elements, relating to the reference plane.

The structural elements comprise a directed order, e.g. grooves in a certain direction, holes drilled in a certain angular to the reference plane or triangular rods, prisms and hemispheres attached to the reference plane. Alternatively the structural elements comprise an undirected order, e.g. grooves with no precise order which can occur, for example, through the undirected use of sandpaper or undirected protruding elements which can occur, for example, through the addition of a substrate with different core sizes. In another alternative the structural elements comprise a directed order as well as an undirected order.

In addition thereto the structural elements are at least partially symmetric among themselves. For example, the structural elements comprise parallel lines or waves. Alternatively they comprise for example centro-symmetric holes or centro-symmetric protruding hemispheres or the structural elements comprise a mesh.

In another alternative the structural elements are at least partially asymmetric among themselves. For instance, through different directed parallel lines which can be achieved through the use of a cutting tool, comprising parallel blades, in different direction. Alternatively the structural elements are asymmetric among themselves, e.g. through grinding with sandpaper.

The structural elements can be generated through mechanical or chemical means, especially grinding, rasping, soldering, cutting, shaping, notching, etching, laser engraving or through the addition a chemical substance or of a substrate. The mechanical and chemical means can be used solitary or successive.

The treatment surface, comprising the structural elements, comprises an average roughness larger than 0.01 µm. The average roughness Rₐ is defined through the arithmetic averaging of the absolute distances of the roughness profile to a reference line within the section of measurements (DIN EN ISO 4287:2009-11-(D)). The range of the average roughness is between 0.01 µm and 1000 µm, in particular between 0.1 µm and 1 µm.

In another embodiment the structural elements comprise a nanostructure or a mesh.

In an alternative embodiment the treatment surface, comprising the structural elements, is integrated in the second electrode. The surface of the electrode is prepared by mechanical or chemical means, particularly by grinding with sandpaper. The mechanical and chemical means can be used solitary or successive.

The first electrode comprises a corona electrode or a flat electrode for generating an electric field. The polymer sheet material is subjected to an electric field between two adjacent electrodes (poling field 150 - 400 MV/m) or in a corona arrangement (corona voltage between 3 and 35 kV, in particular 10 - 25 kV).At the same time is the polymer sheet exposed to a temperature between 100°C and 180°C, in particular 120°C and 150°C. The temperature treatment is performed between 1 and 10 minutes, in particular between 2 and 5 minutes. The polymer sheet material is cooled after the temperature treatment while still being subjected to the electric field.

In an alternative embodiment the polymer sheet material comprises a copolymer, especially poly(vinylidene fluoride-trifluoroethylene).

In an embodiment the appropriate treatment of the bottom side of the polymer sheet material and the appropriate treatment of the upper side of the polymer sheet material, according to the method described above, takes place subsequently. The polymer sheet material is turned and the upper side of the polymer sheet material is positioned on the treatment surface, comprising the structural elements, and treated accordingly to the above described method.

In another embodiment the appropriate treatment of the bottom side of the polymer sheet material and the appropriate treatment of the upper side of the polymer sheet material, according to the method described above, takes place simultaneously. Additionally a second treatment surface, comprising structural elements, is positioned on the upper side of the polymer sheet material. The polymer sheet material is treated according to the method described above. Alternatively the treatment surface, comprising the structural elements, is integrated in the first electrode and / or the second electrode. The surface of the electrode is prepared by mechanical or chemical means, particularly by grinding with sandpaper. The mechanical and chemical means can be used solitary or successive.

In an embodiment the first electrode is not fixed on a certain position and can be moved in a certain direction during the appropriate treatment. Alternatively the first electrode is fixed in a certain position and the polymer sheet material and / or the structured treatment surface and / or the second electrode can be moved during the appropriate treatment. The electrodes, the polymer sheet material and the structured treatment surface can be moved separately or simultaneously.

The polymer sheet material with piezoelectric properties comprising PVDF or co-polymers thereof, especially poly(vinylidene fluoride-trifluoroethylene), is producible by a method according to the above mentioned steps, in particular by subjecting the polymer sheet material to an electric field between two electrodes while subjecting the polymer sheet material at the same time to a temperature treatment with a temperature of above 100°C. During the temperature treatment and the simultaneous subjection to an electric field the polymer sheet material is positioned on a treatment surface wherein the treatment surface comprises structural elements.

The polymer sheet material comprises a piezoelectric d₃₃ coefficient (i.e. measured in the direction of the thickness of the polymer sheet) of the polymer sheet material which is larger than 100 pC/N, in particular between 1000 and 1800 pC/N, whereas the piezoelectric d₃₁ coefficient (i.e. measured in the longitudinal direction of the polymer sheet) is still between 20 and 35 pC/N. Furthermore the pyro coefficient p of the polymer sheet material is between 3.5 and 5 nC/cm²K. The thickness of the polymer sheet material is in the range of 0.01 µm and 1000 µm, in particular between 0.1 µm and 100 µm.

In the following different embodiments of a polymer sheet material with piezoelectric properties and different embodiments of the treatment surface, comprising the structural elements, are described, in which
- Fig. 1: shows schematically an embodiment to manufacture polymer sheet materials;
- Fig. 2: shows schematically structural elements;
- Fig. 3: shows schematically a profile of a treatment surface comprising structural elements relevant to a reference plane;
- Fig. 4: shows schematically structural elements of a treatment surface in a directed, partial symmetric order;
- Fig. 5: shows schematically structural elements of a treatment surface in a directed, symmetric order;
- Fig. 6: shows schematically structural elements of a treatment surface in a directed, asymmetric order;
- Fig. 7: shows schematically structural elements of a treatment surface in an undirected, partial symmetric order;
- Fig. 8: shows schematically structural elements of a treatment surface in an undirected, symmetric order;
- Fig. 9: shows schematically structural elements of a treatment surface in an undirected, asymmetric order;
- Fig. 10A: shows schematically a profile of a polymer sheet material on a treatment surface comprising structural elements;
- Fig. 10B: shows schematically a profile of a polymer sheet material on a treatment surface comprising structural elements;
- Fig. 11: shows schematically a profile of a treatment surface comprising structural elements relating to an average roughness;
- Fig. 12: shows schematically a second embodiment to manufacture polymer sheet materials;
- Fig. 12A: shows schematically a third embodiment to manufacture polymer sheet materials;
- Fig. 13: shows schematically a forth embodiment to manufacture polymer sheet materials;
- Fig. 14: shows schematically a fifth embodiment to manufacture polymer sheet materials;

Before describing the treatment of a polymer sheet material, one way to manufacture such a material is described.

A solution (4 mass-%) of the polymer material, comprising PVDF or co-polymers thereof, in an appropriate solvent (e.g. mixture of Dimethylsulfoxide and Acetone) is poured on a flat surface (e.g. a glass top). The solvent is than evaporated at a temperature range between 80 - 120 °C, in particular at 100 °C. After the evaporation of the solvent the polymer sheet material is formed and subsequently the temperature is raised, for a short time interval, to 150 °C. Afterwards the flat surface is cooled for 10 seconds through contact with a cold metal plate. Accordingly the flat surface and the polymer sheet material are put under cold water. The polymer sheet material can now be detached from the flat surface.

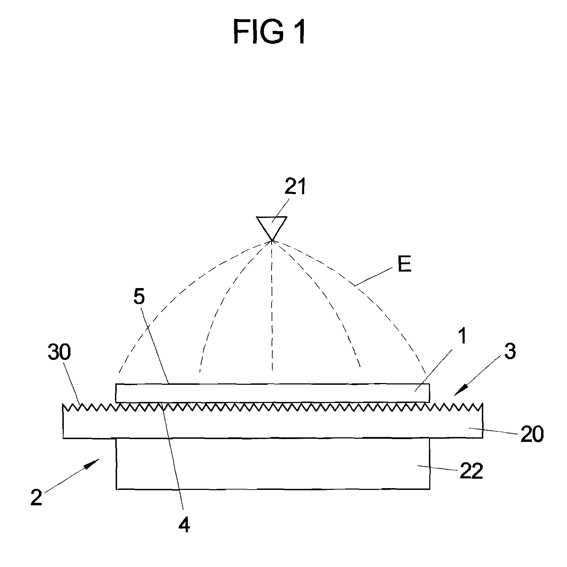

Figure 1 shows schematically an embodiment 2 to manufacture the polymer sheet materials 1.

The embodiment 2 comprises two electrodes 21 and 22 and a treatment surface 20 which is arranged in between the two electrodes 21 and 22. The polymer sheet material 1 with piezoelectric properties comprising PVDF or co-polymers thereof, especially trifluoroethylene, is arranged on the treatment surface 20.

Suitable piezoelectric polymers are the semicrystalline poly(vinylidene fluoride) (PVDF) and related copolymers like VDF with trifluorotehylene (TrFE). It is known in the art that the orientation of molecules is obtained through a so called "poling". The polymer material is heated to an appropriate temperature and a high electrical field is applied in order to achieve a cooperative alignment of constituent dipoles which causes a remanent polarization. PVDF must be drawn prior to poling in order to convert its crystalline phase from nonpolar α to ferroelectric β. Copolymers of VDF with TrFE do not need such treatment because they directly crystallize from the melt or solution into the ferroelectric phase analogous to β PVDF.

In the embodiment 2 the polymer sheet material 1 is exposed to a temperature of above 100°C and simultaneously subjected to an electric field. Additionally the polymer sheet material 1 is arranged on the treatment surface 20 which comprises structural elements 3. This simultaneous treatment of the polymer sheet material 1 with a high temperature and an electric field, while arranged on the treatment surface 20, comprising the structural elements 3, leads an to an inhomogeneity in the electric field which leads to an additional anisotropy in the polymer sheet material and generates improved piezoelectric properties.

In the embodiment 2 the total area of the bottom side 4 of the polymer sheet material 1 is in contact with the structural elements 3 of the treatment surface 20. Alternatively only a partial area of the bottom side 4 of the polymer sheet material 1 is in contact with the structural elements 3 of the treatment surface 20.

The electric field is generated between the first electrode 21 and the second electrode 22. The first electrode 21 comprises a corona electrode, for generating an electric field, in particular a corona. The voltage between the electrodes 21 and 22 is between 3 to 35 kV, in particular 10 to 25 kV. Alternatively a flat electrode can be used(poling field 150 - 400 MV/m).

At the same time the polymer sheet material 1 is exposed to a temperature between 100°C and 180°C, in particular 120°C and 150°C.

The treatment surface 20 comprises a material with a melting point over 200°C, in particular a metal or a dielectric material.

The temperature treatment is performed between 1 and 10 minutes, in particular between 2 and 5 minutes. The temperature treatment is effected, for example by means of a heating surface, convection heat or a radiation source. The polymer sheet material 1 is cooled after the temperature treatment while still being subjected to the electric field E, e.g. by means of water or air cooling.

The treatment surface 20 and the structural elements 3 comprise metal or dielectric material, but not necessarily the same material. The structural elements 3 are generated by mechanical or chemical means, e.g. grinding, rasping, soldering, etching, laser engraving and / or addition of a substrate and / or addition of a chemical substance, particularly by grinding with sandpaper. Alternatively the treatment surface comprises a mesh. It is also possible to use combinations of different structures.

At least parts of the structural elements 3, comprising individual structural elements 30, comprise the same or different characteristics, i.e. structure, direction, shape and dimension. In Fig. 1 to 14, the individual structural elements 30 are shown to make up the structural elements 3 which are part of the treatment surface 20.

The structural elements 3 are symbolized by a triangular shape, representative for any kind of structural elements 3 to simplify the schematic profile. The directed and symmetric order of structural elements 3 in Figure 1 is for reasons of clarity and comprehensibility only. Any directed or undirected order as well as any symmetry or asymmetry and combinations thereof is possible for the structural elements 3. Alternatively the structural elements 3 comprise a nanostructure or a mesh. It is also possible to use combinations of different structures.

The use of different kind of structural elements 3 (see the following figures) enables enhanced piezoelectric properties.

The structure elements 3 have an average roughness Rₐ larger than 0.01 µm. The average roughness Rₐ is defined through the arithmetic averaging of the absolute distances of the roughness profile to a reference line within the section of measurements (DIN EN ISO 4287:2009-11-(D)). The range of the average roughness is between 0.01 µm and 1000 µm, in particular between 0.1 µm and 1 µm.

Additionally to the method described above both sides of the polymer sheet material can receive the same appropriate treatment. The appropriate treatment of each side takes place subsequently. The polymer sheet material 1 is turned after the appropriate treatment of the bottom side 4 and the upper side 5 is positioned on the treatment surface 20, comprising the structural elements 3, and is treated accordingly to the method described above.

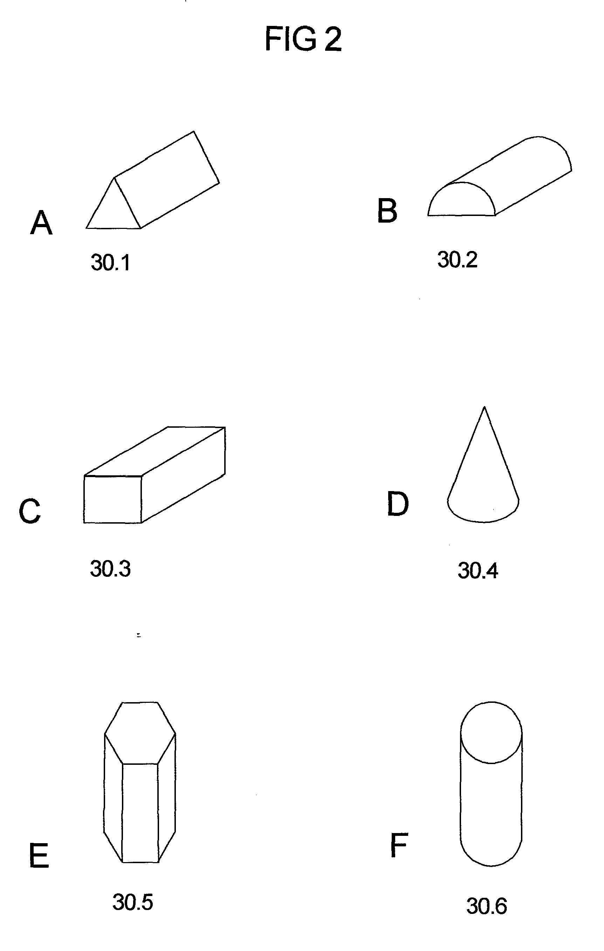

The structural elements 3 effect the piezoelectric properties during the appropriate treatment (see Figure 1). Possible individual structural elements 30 are displayed in Figure 2. The depicted images of the individual structural elements 30.1 to 30.6 are not exclusive and they only display a range of possible, different individual structural elements 30. They comprise a, e.g. triangular A, semicircular B, rectangular C, conical D, prismatic E, cylindrical F shape.

The structural elements 3 comprise the same or different characteristics, i.e. structure, direction, shape and dimension and are not restricted to a specific shape. They can be combined independently and arbitrarily.

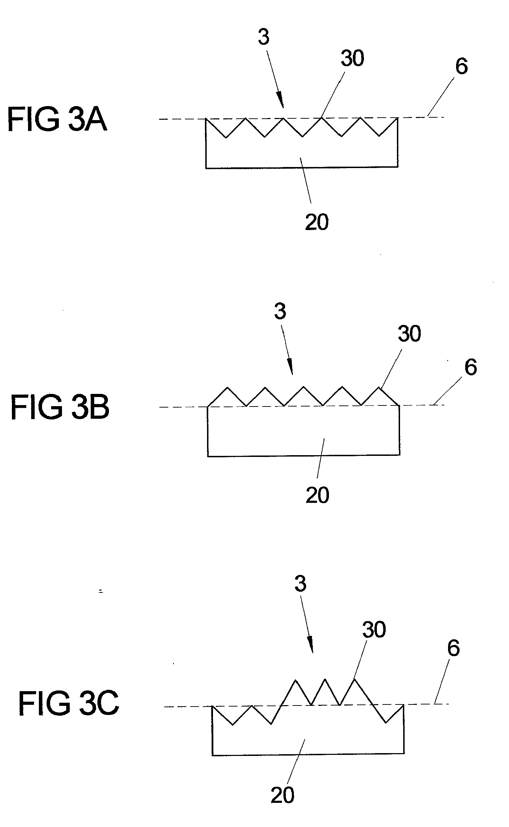

The structure elements 3 can comprise indentations or protruding elements or both relevant to a reference plane 6. The Figure 3A to Figure 3C shows schematically a profile of a treatment surface 20 comprising structural elements 3 relevant to a reference plane 6. The triangular shape, the directed and symmetric order of the structural elements 3 are only symbolic for any kind of structural elements 3 and are used to simplify the schematic profile.

The structural elements 3 can be arranged below a reference plane 6, in particular by indentations into at least parts of the treatment surface 20 (Figure 3A). Alternatively the structural element 3 can be arranged above the reference plane 6, in particular by protruding elements on at least parts of the treatment surface 20 (Figure 3B). The position of structural elements 3 above or below the reference plane 6 is not exclusive. The indentations below the reference plane 6 into at least parts of the treatment surface 20 or the protruding elements above at least parts of the reference plane 6 can be combined independently and arbitrarily (Figure 3C).

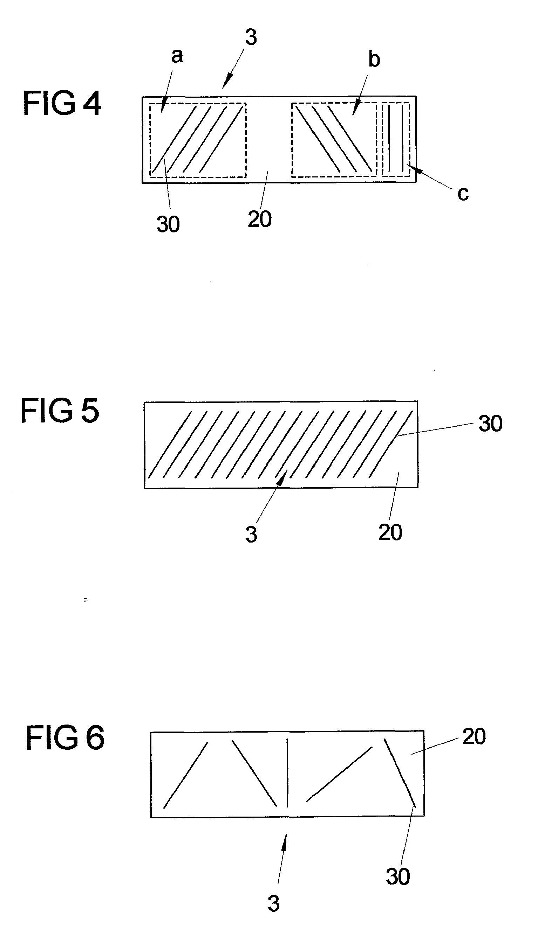

The order of the structural elements 3 of a treatment surface 20 can be directed or undirected. Furthermore the structural elements 3 can be symmetric or asymmetric. The Figures 4 to 9 show schematically structural elements 3 in a directed and or undirected order, wherein the structural elements 3 are at least partially symmetric or at least partially asymmetric among themselves.

In Figure 4 to 9 the structural elements 3 are represented by lines for reasons of clarity and comprehensibility. They indicate any structural elements 3 and represent either indentations below the reference plane 6 or protruding elements above the reference plane 6.

The Figure 4 to 6 show schematically structural elements 3 in a directed order.

The structural elements 3 shown in Figure 4 are partially symmetric among themselves. In the zone a, b or c they are symmetric in each distinct zone among themselves. In a comparison with the different zones they are asymmetric among themselves. The structural elements 3 in Figure 4 are directed and partially symmetric (and therefore partially asymmetric) among themselves, e.g. grooves in a certain direction, holes drilled in a certain angular or triangular rods, prisms and hemispheres attached to the treatment surface 20.

Alternatively the Figure 5 shows schematically structural elements 3 in a directed order. They are symmetric among themselves which can be achieved, e.g. through the use a cutting tool, with the edges locked in the same particular distances to each other, in a particular direction.

In another alternative the Figure 6 shows schematically structural elements 3 in a directed order. They are asymmetric among themselves which can be achieved, e.g. through the use of a one edged cutting tool.

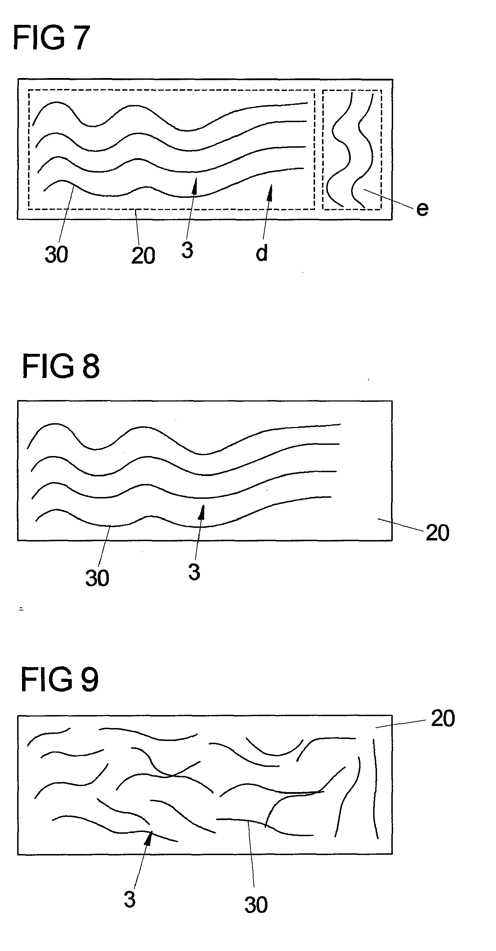

The Figure 7 to 9 show schematically structural elements 3 in an undirected order.

The structural elements 3 shown in Figure 7 are partially symmetric among themselves. In the zone d or e they are symmetric in each distinct zone among themselves. In a comparison with the different zones they are asymmetric among themselves. The structural elements 3 in Figure 7 are undirected and only partially symmetric (and therefore partially asymmetric) among themselves, e.g. grooves with no precise order which can occur through the undirected use of sandpaper, undirected protruding elements which can occur through the addition of a substrate with different core sizes.

Alternatively the Figure 8 shows schematically structural elements 3 in an undirected order. They are symmetric among themselves which can be achieved, e.g. through the use a cutting tool, with the edges locked in the same particular distances to each other, in no particular directions.

In another alternative the Figure 9 shows schematically structural elements 3 in an undirected order. They are asymmetric among themselves which can be achieved, e.g. through etching with a chemical substance.

The use of symmetric or asymmetric structural elements 3 in a directed or undirected order is not exclusive and they can be combined independently and arbitrarily.

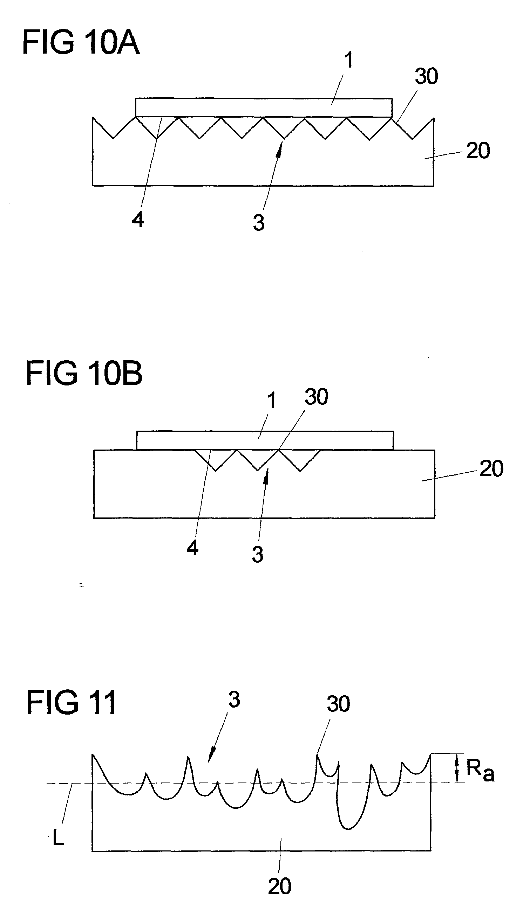

The Figure 10A and Figure 10B show schematically a profile of a polymer sheet material 1 on a treatment surface 20 comprising structural elements 3. The total area of the bottom side 4 of the polymer sheet material 1 is in contact with the structural elements 3 of the treatment surface 20 (Figure 10A). Alternatively only a partial area of the bottom side 4 of the polymer sheet material 1 is in contact with the structural elements 3 of the treatment surface 20 (Figure 10B).

The Figure 11 shows schematically a profile of a treatment surface 20 comprising structural elements 3 relating to an average roughness Rₐ (DIN EN ISO 4287:2009-11-(D)). The average roughness Rₐ is defined through the arithmetic averaging of the absolute distances of the roughness profile to an average line L within the section of measurements. The treatment surface 20, comprising the structural elements 3, has an average roughness Rₐ larger than 0.01 µm. The range of the average roughness is between 1 µm and 1000 µm, in particular between 1 µm and 100 µm.

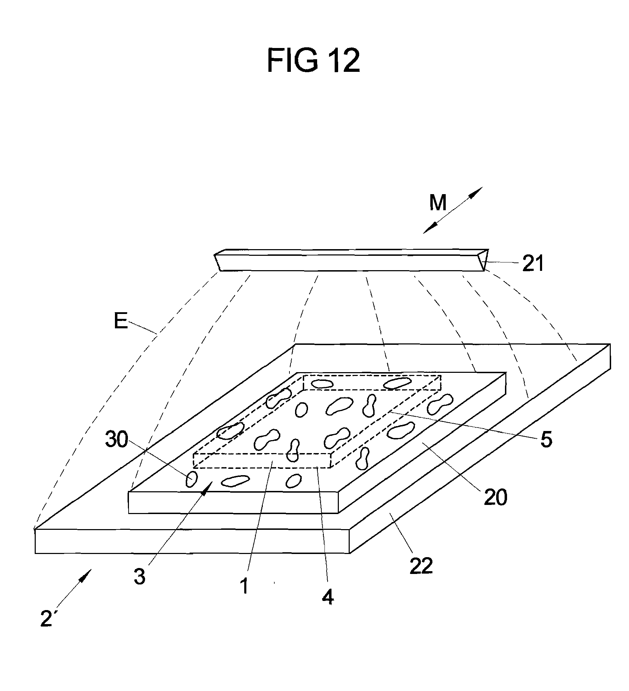

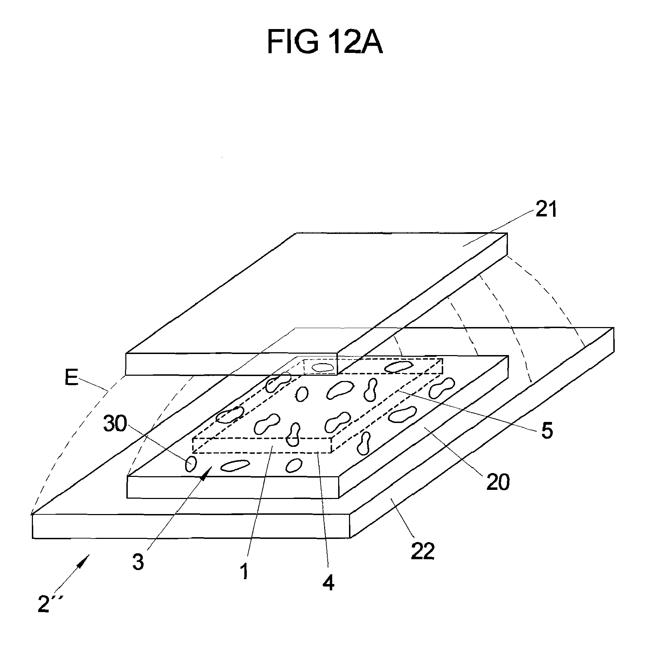

A second embodiment 2' to manufacture polymer sheet materials 1 is shown schematically in Figure 12, whereas unchanged elements have the same reference number. Reference is made to the corresponding description of Fig. 1.

The structural elements 3 are in an undirected order. They are totally asymmetric among themselves.

The electric field is generated between the first electrode 21 and the second electrode 22. The first electrode 21 comprises a corona electrode with a wedged structure for generating an electric field. The voltage between the electrodes 21 and 22 is between 3 to 35 kV, in particular 10 to 25 kV. Alternatively the first electrode comprises corona electrode with at least one corona tip. In an alternative the first electrode comprises a flat electrode for generating an electric field (poling field 150 - 400 MV/m).

The polymer sheet material 1 is treated according to the method described above. A description concerning the average roughness Rₐ, the electric field, the use of a mesh as a treatment surface, the temperature treatment, the subsequent treatment of the upper side 5 and the general process is given in connection with Fig. 1 to 11.

In distinction from Figure 1 the first electrode 21 is not fixed on a certain position. The first electrode 21 is moved in a direction (M) during the appropriate treatment. Alternatively the first electrode 21 is fixed in a certain position and the polymer sheet material 1 and / or the structured treatment surface 20 and / or the second electrode 22 is moved during the appropriate treatment. In an alternative the first electrode is moved in the direction (M) during the appropriate treatment and simultaneously the polymer sheet material 1 and / or the structured treatment surface 20 and / or the second electrode 22 is moved in an alternative direction (M') during the appropriate treatment.

A third embodiment 2" to manufacture polymer sheet materials 1 is shown schematically in Figure 12A, whereas unchanged elements have the same reference number. Reference is made to the description of Fig. 1.

In the third embodiment 2" the structured treatment surface 20, comprises metal or dielectric material. The structural elements 3 are generated by the addition of a substrate. Alternatively the structural elements 3 are generated by chemical means, in particular through etching with a chemical substance. In an alternative the structured treatment surface 20 comprises a mesh. It is also possible to use combinations of different structures.

The structural elements 3 are in an undirected order. They are totally asymmetric among themselves.

The electric field is generated between the first electrode 21 and the second electrode 22. The first 21 and second electrode 22 comprise a flat electrode, for generating an electric field (poling field 150 - 400 MV/m). Alternatively a corona electrode can be used.

The polymer sheet material 1 is treated according to the method described above. The average roughness Rₐ, the electric field, the use of a mesh as a treatment surface, the temperature treatment, the subsequent treatment of the upper side 5 and the general process are described in connection with Fig. 1 to 11.

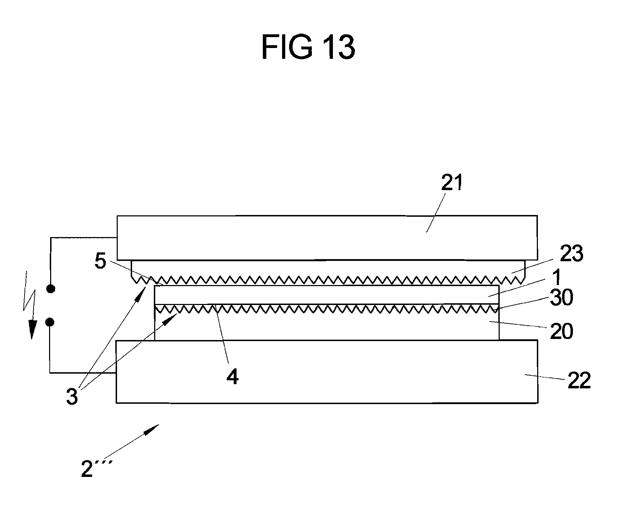

The Figure 13 shows schematically a forth embodiment 2"' to manufacture polymer sheet materials 1, whereas unchanged elements have the same reference number. Reference is made to the description of Fig. 1.

In distinction from Figure 1 the bottom side 4 and the upper side 5 of the polymer sheet material 1 are treated simultaneously. Additionally a second treatment surface 23, comprising structural elements 3, is positioned on the upper side 5 of the polymer sheet material 1. The first electrode 21 is positioned above the p second treatment surface 23.

The polymer sheet material 1 is treated according to the method described above. The average roughness Rₐ, the electric field, the use of a mesh as a treatment surface, the temperature treatment, the subsequent treatment of the upper side 5 and the general process are described in connection with Fig. 1 to 12.

Alternatively the treatment surface 20 and 23, comprising the structural elements 3, is integrated in the first electrode 21 and the second electrode 22. The surface of the electrodes 21 and 22 is prepared by mechanical or chemical means, e.g. grinding, rasping, soldering, cutting, shaping, notching, etching, laser engraving and / or through the addition of a substrate and / or a chemical substance, particularly by grinding with sandpaper.

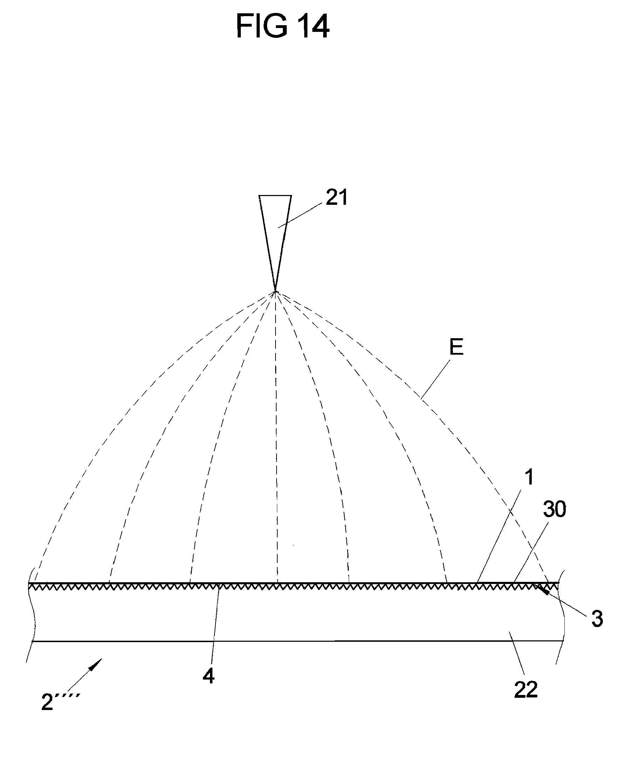

The Figure 14 shows schematically a fifth embodiment 2"" to manufacture polymer sheet materials whereas unchanged elements have the same reference number. Reference can be made to the description of Fig. 1.

In distinction from Figure 1 the treatment surface 20, comprising the structural elements 3, is integrated in the second electrode 22.

The surface of the electrode 22 is prepared by mechanical or chemical means, e.g. grinding, rasping, soldering, cutting, shaping, notching, etching, laser engraving and / or through the addition of a substrate and / or a chemical substance, particularly by grinding with sandpaper.

The polymer sheet material 1 is treated according to the method described above. For a description concerning the average roughness Rₐ, the electric field, the use of a mesh as a treatment surface, the temperature treatment, the subsequent treatment of the upper side 5 and the general process it is referred to the Figures 1 to 13 as described above.
- 1: polymer sheet material
- 2: embodiment to manufacture polymer sheet materials
- 3: structural elements
- 4: bottom side of the polymer sheet material
- 5: upper side of the polymer sheet material
- 6: reference plane

- 20: treatment surface
- 21: first electrode
- 22: second electrode
- 23: second treatment surface

- 30: individual structural elements

- E: electrical field
- L: average Line
- Rₐ: average roughness
- M: direction

## Claims

1. Method for manufacturing a polymer sheet material with piezoelectric properties comprising PVDF or co-polymers thereof by
a) subjecting the polymer sheet material (1) to an electric field (E) between two electrodes (21, 22), in particular a corona electrode arrangement,
b) while subjecting the polymer sheet material (1) at the same time to a temperature treatment with a temperature of above 100°C,
c) during process steps a) and b) the polymer sheet material (1) is positioned on a treatment surface (20),
d) wherein the treatment surface (20) comprises structural elements (3) for generating inhomogeneity in the electric field (E).

2. Method according to claim 1, **characterized in that** at least a partial area of the bottom side (4) of the polymer sheet material (1) is in contact with the structural elements (3) of the treatment surface (20).

3. Method according to claim 1 and 2, **characterized in that** the structural elements (3) comprise the same or different characteristics, e.g. structure, direction, shape and dimension.

4. Method according to one of the preceding claims, **characterized in that** at least parts of the structural elements (3), in particular by indentations into at least parts of the treatment surface (20), are positioned below a reference plane (6), and / or at least parts of the structural elements (3), in particular by protruding elements on at least parts of the treatment surface (20), are arranged above the reference plane (6).

5. Method according to one of the preceding claims, **characterized in that** at least parts of the structural elements (3) are at least partially symmetric or at least partially asymmetric among themselves.

6. Method according to one of the preceding claims, **characterized in that** mechanical or chemical means are used, especially grinding, rasping, soldering, etching, laser engraving, addition of a chemical substance and / or addition of a substrate, to generate the structural elements (3).

7. Method according to one of the preceding claims, **characterized in that** the treatment surface (20), comprising the structural elements (3), has an average roughness (Rₐ) larger than 0.01 µm, in particular in the range of 0.01 µm and 1000 µm, in particular between 0.01 µm and 1 µm.

8. Method according to one of the preceding claims, **characterized in that** the at least parts of the structural elements (3) comprise a nanostructure and / or a mesh.

9. Method according to one of the preceding claims, **characterized in that** the subjection to the electric field (E) and the temperature treatment is performed between 1 and 10 minutes, in particular between 2 and 5 minutes.

10. Method according to one of the preceding claims, **characterized in that** the polymer sheet material (1) is cooled after the temperature treatment while still being subjected to the electric field (E).

11. Method according to one of the preceding claims, **characterized in that** the appropriate treatment of the bottom side (4) of the polymer sheet material (1) and the appropriate treatment of the upper side (5) of the polymer sheet material (1) takes place
a) subsequently, by means of turning the polymer sheet material (1) and positioning the upper side (5) of the polymer sheet material (1) on the treatment surface (20), comprising the structural elements (3),
or
b) simultaneously, by means of positioning a second treatment surface (23), comprising structural elements (3), on the upper side (5) of the polymer sheet material (1)
before appropriate treatment.

12. Method according to one of the preceding claims **characterized in that** the treatment surface (20), comprising the structural elements (3), is integrated in the first electrode (21) and / or the second electrode (22).

13. Method according to one of the preceding claims **characterized in that** the first electrode (21), the polymer sheet material (1), the structured treatment surface (20) and / or the second electrode (22) is moved in the direction (M) during the appropriate treatment.

14. Polymer sheet material with piezoelectric properties comprising PVDF or co-polymers thereof producible by a method comprising the following steps, in particular by method according to any of the claims 1 to 13:
a) subjecting the polymer sheet material (1) to an electric field (E) between two electrodes (21, 22)
b) while subjecting the polymer sheet material (1) at the same time to a temperature treatment with a temperature of above 100°,
c) during a) and b) the polymer sheet material (1) is positioned on a treatment surface (20),
d) wherein the treatment surface (20) comprises structural elements (3) for generating inhomogeneity in the electric field (E).

15. Polymer sheet material according to claims 14, **characterized in that** the piezoelectric d₃₃ coefficient is larger than 100 pC/N, in particular between 1000 and 2000 pC/N , that the piezoelectric d₃₁ coefficient is between 20 and 35 pC/N that the pyro coefficient p is between 3,5 and 5 nC/cm²K and that the thickness is between 0.01 µm and 1000 µm.
